## Europäisches Patentamt
## European Patent Office
## Office européen des brevets

(19)

(11) Veröffentlichungsnummer: **0 191 293**
**B1**

(12) **EUROPÄISCHE PATENTSCHRIFT**

(45) Veröffentlichungstag der Patentschrift:
02.08.89

(51) Int. Cl.⁴: **H 01 J 37/244**

(21) Anmeldenummer: **86100214.5**

(22) Anmeldetag: **09.01.86**

(54) Detektor für Rückstreuelektronen.

(30) Priorität: **12.01.85 DE 3500903**

(43) Veröffentlichungstag der Anmeldung:
**20.08.86 Patentblatt 86/34**

(45) Bekanntmachung des Hinweises auf die Patenterteilung:
**02.08.89 Patentblatt 89/31**

(84) Benannte Vertragsstaaten:
**DE GB NL**

(56) Entgegenhaltungen:
**EP-A-0 018 031**
**WO-A-84/00443**
**DE-A-2 915 073**
**GB-A-2 006 809**

**PATENTS ABSTRACTS OF JAPAN, Band 4, Nr. 185**
**(E-38) 667 , 19. Dezember 1980; & JP - A - 55 128 242**

(73) Patentinhaber: **Firma Carl Zeiss, D-7920 Heidenheim (Brenz) (DE)**
(84) Benannte Vertragsstaaten: **DE NL**

(73) Patentinhaber: **CARL- ZEISS- STIFTUNG trading as CARL ZEISS, D-7920 Heidenheim (Brenz) (DE)**
(84) Benannte Vertragsstaaten: **GB**

(72) Erfinder: **Kurz, Dieter, Dr., Heulenbergweg 52, D-7080 Aalen (DE)**
Erfinder: **Schäfer, Norbert, Dipl.- Ing., Kantstrasse 1, D-7081 Essingen (DE)**

## Beschreibung

Die vorliegende Erfindung betrifft einen Detektor für Rückstreuelektronen mit einem Szintillator, dessen scheibenförmige Hauptoberfläche senkrecht zur Elektronenstrahlrichtung ausgerichtet ist, und einer an den Szintillator angesetzten Lichtleitvorrichtung aus festen Teilen, wobei die Ableitung der Sekundärstrahlung vom Szintillator zu einem Empfänger in einer zur Elektronenstrahlrichtung annähernd senkrechten Ebene erfolgt. Derartige Detektoren werden vorzugsweise in Rasterelektronenmikroskopen (REM bzw. SEM für scanning electron microscope) verwendet.

In einem Rasterelektronenmikroskop wird das zu untersuchende Präparat mit einem auf das Präparat fokussierten Elektronenstrahl mäanderförmig abgetastet. Dabei kommt es zu verschiedenen Wechselwirkungen in dem Präparat. Am wichtigsten sind niederenergetische Sekundärelektronen (SE, secondary electrons) und mit geringem oder keinem Energieverlust an dem Präparat gestreuten Elektronen des Elektronenstrahles, die sog. Rückstreuelektronen (back scattered electrons, abgekürzt BSE). Mit Hilfe geeigneter Detektoren und einem Bildaufbau entsprechend der Abtastbewegung des Elektronenstrahles werden z. B. auf einem Monitor Bilder erzeugt, die der Elektronenemission des Präparates entsprechen. Da bei ebenen Präparaten der Rückstreuelektronenkoeffizient eine Funktion der Ordnungszahl Z ist, können mit Detektoren, die nur auf Rückstreuelektronen ansprechen, Materialanalysen in Mikrobereichen durchgeführt werden (sog. Materialkontrast).

Aus der EP-A-10 018 031 ist ein Detektionssystem bekannt, das mehrere Detektorelemente mit flexiblen optischen Lichtleitern enthält. An einem Ende der Lichtleiter befindet sich jeweils ein Lichttrichter mit einem Eintrittsschirm. Die anderen Enden der Lichtleiter sind mit einem lichtdurchlässigen Block gekoppelt, der als Wandabdichtung dient. Das Detektorsystem enthält Selektionsmittel zum Auswählen von Signalen aus zumindest einem der Detektorelemente. Zur Messung der rückgestreuten Elektronen müssen die Detektorelemente zwischen der letzten elektronenoptischen Linse und dem Präparat angeordnet werden. Dieser Abstand läßt sich jedoch bei diesen Detektorelementen nicht so klein machen, wie das bei den für hohe Auflösung erforderlichen kurzbrennweitigen Objektiven notwendig ist.

Aus einer Veröffentlichung von Autrata e. a. (Scanning Electron Microscopy 1983/II, 489) ist die Verwendung von cer-dotierten YAP- und YAG-Einkristallen bekannt. Dort sind Detektoren mit scheibenförmigen Einkristallen beschrieben, die in der Mitte eine Bohrung für den Elektronenstrahl haben und dadurch auch in einen schmalen Zwischenraum zwischen der letzten elektronenoptischen Linse und dem Präparat eingebracht werden können. Die Einkristalle sind über Lichtleitvorrichtungen mit Photovervielfachern verbunden. Bei einer kreisförmigen Ausführung des Einkristalles ist die Hälfte der kreisförmigen Seitenwand an die Lichtleitvorrichtung angekittet. Bei einer quadratischen Ausführung des Einkristalles ist eine Seitenfläche an die Lichtleitvorrichtung angekittet, wobei eine $Al_2O_3$-Schicht mit einer Dicke von $\lambda/4$ einen besseren Übergang der Photonen in die Lichtleitvorrichtung bewirkt. Bei einer weiteren Ausführung mit einem kreisförmigen Einkristall sitzt eine Kreisfläche auf dem flachen Teil einer in einer Richtung ausgebildeten Lichtleitvorrichtung, wodurch ein größeres Ausgangssignal für den Detektor erreicht wird.

Auch aus der GB-A-2 006 809 ist ein Detektor bekannt, bei dem der scheibenförmige Szintillator auf eine plattenförmige Lichtleiteinrichtung aufgebracht ist, welche die Sekundärstrahlung zum Empfänger leitet.

Diese bekannten flach ausgebildeten Detektoren mit festen Lichtleitern haben den Nachteil, daß bei einheitlichen Präparaten die von verschiedenen Stellen rückgestreuten Elektronen unterschiedlich starke Signale auslösen; insbesondere bei niedrigen Vergrößerungen entstehen ungleichmäßig ausgeleuchtete Bilder. Dieser Nachteil macht sich besonders störend bemerkbar, wenn Materialanalysen ausgeführt werden.

Der vorliegenden Erfindung liegt daher die Aufgabe zugrunde, einen Detektor entsprechend dem Oberbegriff des Anspruches 1 zu schaffen, mit dem auch bei niedrigen Vergrößerungen eine gleichmäßige Ausleuchtung der gesamten Bildfläche erreicht wird, der zugleich auch für hohe Vergrösserungen geeignet ist und der außerdem ein gutes Signal-Rausch-Verhältnis hat.

Die gestellte Aufgabe wird erfindungsgemäß dadurch gelöst, daß die Lichtleitvorrichtung zwei reflektierende Flächen enthält, welche auf einander gegenüberliegenden Seiten des Szintillators angeordnet sind und welche die Sekundärstrahlung über Lichtleitstäbe zum Empfänger leiten.

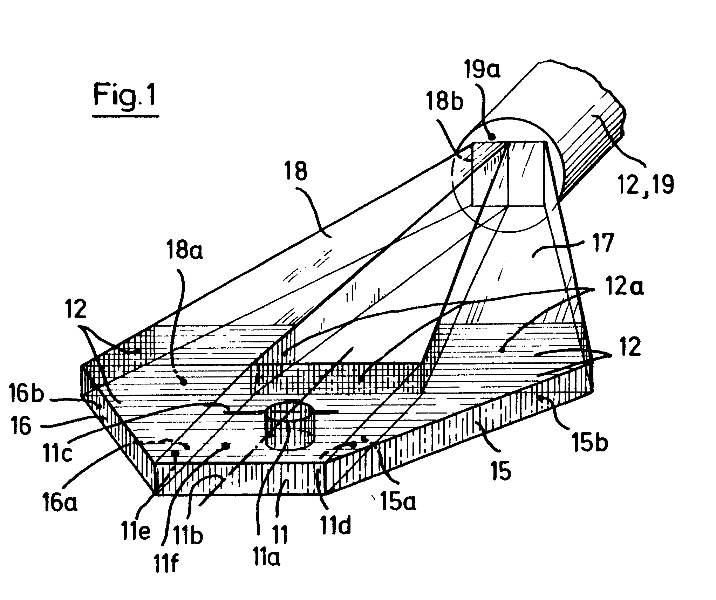

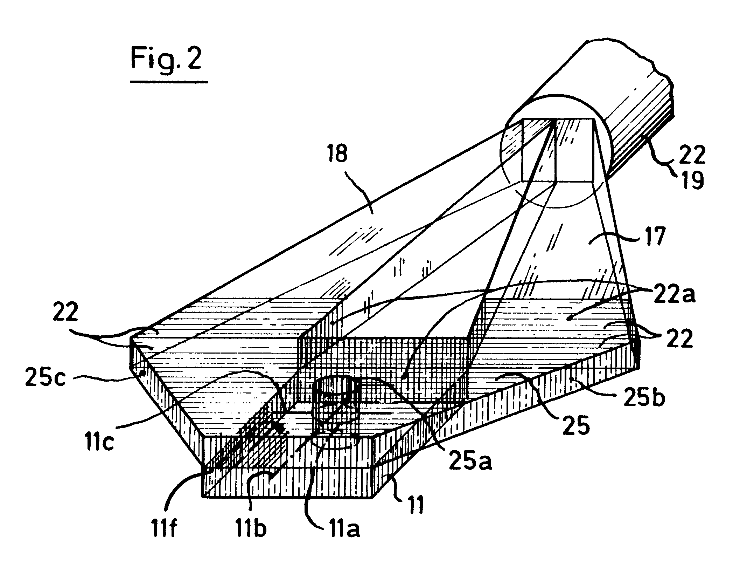

Als Lichtleitvorrichtung können dabei sowohl massive Teile (wie z. B. in Figur 1 und 2 beschrieben) oder Lichttrichter mit Lichtleitern (wie im Stand der Technik angegeben) als auch reine Faseroptik verwendet werden. Der scheibenförmige Szintillatorkristall kann quadratisch oder kreisförmig sein.

In einer vorteilhaften Ausführungsform ist der Szintillatorkristall quadratisch und die Lichteintrittsflächen der Lichtleitvorrichtung sind an zwei einander gegenüberliegenden Seitenwänden des quadratischen Szintillatorkristalles angebracht. Diese Ausführungsform hat den Vorteil, daß sie besonders flach ist und daher für sehr geringe Abstände zwischen Präparat und letzter elektronenoptischer Linse geeignet ist.

In einer besonders vorteilhaften Ausführungsform besteht die Lichtleitvorrichtung aus zwei Umlenkprismen, zwei Lichtleitstäben und einem zylinderförmigen Lichtleiter.

In einer anderen vorteilhaften Ausführungsform ist die Lichtleitvorrichtung an einer Hauptoberfläche des Szintillatorkristalles angesetzt. Die Lichtleitvorrichtung besteht in diesem Fall aus einem plattenförmigen Teil, das an seinen Seitenwänden zwei reflektierende Spiegelflächen hat, welche die Sekundärstrahlung in Lichtleitstäbe reflektieren, die mit einem zylinderförmigen Lichtleiter verbunden sind.

Als Szintillatorkristall ist vorzugsweise YAP: $Ce^{3+}$ vorgesehen. Dieser Einkristall hat eine gute Quantenausbeute und dadurch ein gutes Signal-Rausch-Verhältnis. Seine kurze Abklingzeit im Bereich von 70ns ermöglicht einen Bildaufbau mit einer Videobandbreite von 7 MHz.

Weitere Ausgestaltungen der Erfindung gehen aus den Unteransprüchen hervor.

Die erfindungsgemäße Ausbildung der Lichtleitvorrichtung und Ankopplung an den Szintillatorkristall erlaubt es, dem Szintillatorkristall eine Dicke von nur 1 mm zu geben. Dadurch sind kurze Arbeitsabstände zwischen der letzten elektronenoptischen Linse und dem Präparat und damit hohe Auflösung möglich, ohne wesentliche Einschränkungen der Präparatmanipulationen. Außerdem ist der Detektor für Ultrohochvakuum geeignet.

Die Erfindung wird im folgenden an Hand von in den Figuren 1 bis 4 dargestellten Ausführungsbeispielen erläutert. Dabei zeigen:

Fig. 1    eine perspektivische Darstellung eines Detektors mit zweiseitiger Abnahme der Sekundärstrahlung vom Szintillatorkristall;

Fig. 2    eine perspektivische Darstellung eines Detektors mit flächenseitiger Abnahme der Sekundörstrahlung vom Szintillatorkristall;

Fig. 3    Beispiele für die symmetrische Abnahme der Sekundärstrahlung und

Fig. 4    weitere Ausführungsdetails eines Detektors.

In Figur 1 ist mit 11 ein scheibenförmiger Szintillatorkristall bezeichnet, der in der Mitte eine Bohrung 11a für den (nicht gezeichneten) Elektronenstrahl hat, welcher unterhalb des Detektors auf das (nicht gezeichnete) Präparat auftrifft. Der Szintillatorkristall 11 hat eine quadratische Form und daher in der Ebene 11f zwei zueinander senkrechte Symmetrielinien 11b und 11c. An die Seitenflächen 11d und 11e des Szintillatorkristalls 11 ist die Lichtleitvorrichtung 12 so angesetzt, daß ihre Lichteintrittsflächen 15a und 16a symmetrisch zu den Symmetrielinien 11b und 11c sind. Auf diese Weise wird eine gleichmäßige Ausleuchtung über das gesamte Bildfeld des abgetasteten Präparates erreicht. Die in die Lichteintrittsflächen 15a und 16a eintretende Sekundärstrahlung des Szintillatorkristalles wird an den Reflexionsflächen 15b und 16b der Umlenkprismen 15 und 16 reflektiert und in die Lichtleitstäbe 17 und 18 geleitet. Diese Lichtleitstäbe gehen von der geringen Dicke 18a der Umlenkprismen 15, 16 und des Szintillatorkristalles 11 auf eine erhebliche größere Dicke 18b an ihrem Ende, wobei ihre Breite abnimmt. Sie sind an die Anfangsfläche 19a des zylinderförmigen Lichtleiters 19 angesetzt. Der zylinderförmige Lichtleiter 19 wird in bekannter Weise vakuumdicht aus der Mikroskopsäule herausgeführt und ist außen mit einem Empfänger, z. B. mit einem Vervielfacher, verbunden.

In einer vorteilhaften Ausführung wird als Szintillatorkristall YAP: $Ce^{3+}$ verwendet. Dieser Kristall hat eine sehr lange Lebensdauer, so daß er mit der Lichtleitvorrichtung 12 verkittet werden kann und auch alle Teile der Lichtleitvorrichtung miteinander verkittet werden können. Die gute Quantenausbeute dieses YAP-Kristalles ermöglicht es, ihm eine Dicke von nur 1 mm zu geben, so daß der Detektor zwischen der letzten elektronenoptischen Linse und dem Präparat nur wenig Platz beansprucht.

Der Szintillatorkristall 11 ist auf seinen freien Oberflächen mit Ausnahme der dem Präparat zugewandten Seite mit einer Spiegelschicht 12a versehen, die auch noch den Anfang der Lichtleitvorrichtung 12 bedeckt. Der folgende Teil der Lichtleitvorrichtung, die vorzugsweise aus Glas hergestellt ist, hat jedoch eine freie Oberfläche. Dort wird die verlustfreie Totalreflexion ausgenutzt.

Figur 2 zeigt eine andere Ausführung des Detektors mit flächenseitiger Abnahme der Sekundärstrahlung des Szintillatorkristalles. Mit 11 ist wieder der Szintillatorkristall und mit 11a die Bohrung für den Elektronenstrahl bezeichnet. Mit seiner Fläche 11f ist der Szintillatorkristall 11 mit dem plattenförmigen Teil 25 der Lichtleitvorrichtung 22 verkittet, das ebenfalls eine Bohrung 25a hat, die über der Bohrung 11a angeordnet ist. Das plattenförmige Teil 25 ist so aufgebaut, daß die Ableitung der Sekundärstrahlung wieder symmetrisch zu den Symmetrieachsen 11b und 11c des Szintillatorkristalles 11 erfolgt. Das plattenförmige Teil 25 hat zwei reflektierende Seitenflächen 25b und 25c, durch welche die Sekundärstrahlung in die Lichtleitstäbe 17 und 18 geleitet wird. Letztere sind entsprechend der Beschreibung zur Figur 1 ausgebildet und mit dem zylinderförmigen Lichtleiter 19 verbunden. Die freien Flächen des Szintillatorkristalles 11 mit Ausnahme der dem Präparat zugewandten Seite und die Flächen am Anfang der Lichtleitvorrichtung 22 sind ebenfalls mit einer Spiegelschicht 22a versehen.

In einer vorteilhaften Ausführungsform wird als Szintillatorkristall ebenfalls YAP: $Ce^{3+}$ verwendet und alle Teile werden fest miteinander verkittet.

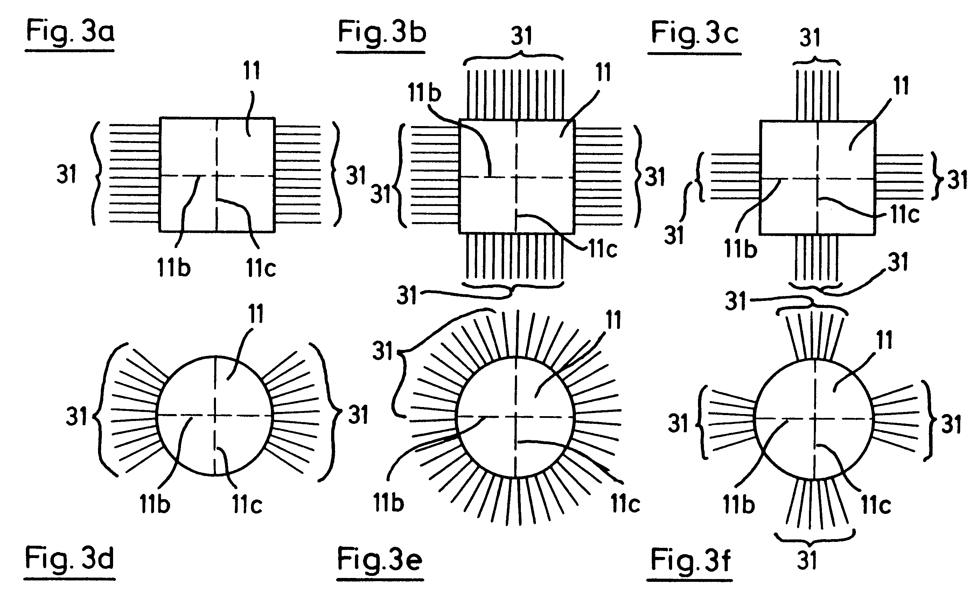

In den Figuren 3a bis 3f sind Ausführungsbeispiele dargestellt, wie die Ableitung der Sekundärstrahlung symmetrisch zu den beiden Symmetrielinien 11b und 11c erfolgen kann. Figur 3a zeigt die mit Figur 1 ausführlich beschriebene zweiseitige Abnahme an einem quadratischen Szintillatorkristall 11. Mit 31 sind Lichtleitfasern bezeichnet, mit denen ebenfalls die Sekundärstrahlung in bekannter Weise abgeführt werden kann. Die Figuren 3b und 3c zeigen eine vierseitige Abnahme, wobei im Fall der Figur 3c nur die mittleren Teile der Seitenflächen ausgenutzt werden.

Die Figuren 3d bis 3f zeigen entsprechende Anordnungen für einen kreisförmigen Szintillatorkristall, wobei es durch die kreisförmige Begrenzung beliebig viele Paare von aufeinander senkrecht stehenden Symmetrielinien gibt, d. h, die Orientierung des Szintillatorkristalles zur Lichtleitvorrichtung ist beliebig.

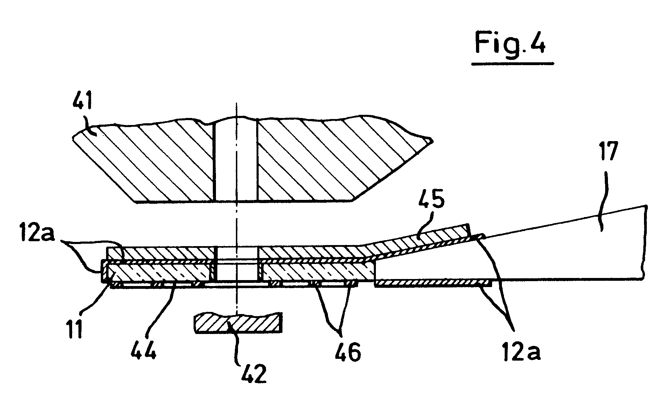

In Figur 4 sind weitere Ausbildungsdetails am Beispiel des mit Figur 1 beschriebenen Detektors dargestellt. Figur 4 zeigt einen Schnitt längs der in Figur 1 mit 11b bezeichneten Symmetrielinie. Mit 41 ist der Polschuh der letzten elektronenoptischen Linse und mit 42 das Präparat bezeichnet. 12a kennzeichnet die bereits besprochenen Spiegelschichten. Auf der dem Präparat zugewandten Seite des Szintillatorkristalles ist eine 50 nm dicke Schicht 44 aus Aluminium aufgebracht. Diese dünne Schicht wird von den Rückstreuelektronen noch durchdrungen und sorgt durch ihre elektrische Leitfähigkeit dafür, daß Aufladungen verhindert werden.

In einer vorteilhaften Ausführungsform befindet sich vor der Aluminiumschicht 44 noch ein Drahtgitter 46, das bei zu geringem Abstand des Präparates 42 vom Detektor eine leitende Verbindung über die Präparathalterung herstellt und damit einen Stromkreis schließt, der ein Warnsignal auslöst, wenn das Präparat zu nahe an den Detektor herangebracht wird.

In einer weiteren vorteilhaften Ausführungsform ist auf dem vorderen Teil des Detektors auf der dem Präparat abgewandten Seite eine Metallplatte 45 aufgekittet, mit welcher eine zusätzliche mechanische Stabilität des Detektors erreicht wird. Die Metallplatte 45 kann auch über den Detektor hinausragen und eine lösbare Verbindung des Detektors mit dem Polschuh 41 aufweisen. Damit wird erreicht, daß der Detektor, der sonst nur über die Lichtleitstäbe 17 und den zylinderförmigen Lichtleiter 19 (Figur 1) in bekannter Weise durch die Wand der Mikroskopsäule geführt ist und dort gehalten wird, wesentlich stabiler zwischen dem Polschuh 41 der letzten elektronenoptischen Linse und dem Präparat 42 gehalten wird.

Derselbe Detektoraufbau kann auch anstelle des Szintillationkristalles mit einem geeigneten Material für die Kathodolumineszenz ausgestattet werden. Für diesen Fall wird das vom Elektronenstrahl im Präparat erzeugte Licht von einer speziellen Glasplatte erfaßt. Diese Glasplatte z. B. aus K5 wird auf der dem Präparat zugewandten Seite mit einer elektrisch leitenden aber optisch transparenten Schicht versehen, auf allen anderen freien Flächen ist sie optisch dicht verspiegelt.

## Patentansprüche

1. Detektor für Rückstreuektronen mit einem Szintillator (11), dessen scheibenförmige Hauptoberfläche (11f) senkrecht zur Elektronenstrahlrichtung ausgerichtet ist, und einer an den Szintillator (11) angesetzten Lichtleitvorrichtung (12, 22) aus festen Teilen, wobei die Ableitung der Sekundärstrahlung vom Szintillator (11) zu einem Empfänger in einer zur Elektronenstrahlrichtung annähernd senkrechten Ebene erfolgt, dadurch gekennzeichnet, daß die Lichtleitvorrichtung (12, 22) zwei reflektierende Flächen (15b, 16b; 25b, 25c) enthält, welche auf einander gegenüberliegenden Seiten des Szintillators (11) angeordnet sind und welche die Sekundärstrahlung über Lichtleitstäbe (17, 15) zum Empfänger leiten.

2. Detektor nach Anspruch 1, dadurch gekennzeichnet, daß der Szintillatorkristall (11) quadratisch ist und die Lichteintrittsflächen (15a, 16a) der Lichtleitvorrichtung (12) an zwei einander gegenüberliegenden Seitenwänden (11d, 11e) des Szintillatorkristalles (11) angesetzt sind.

3. Detektor nach Anspruch 2, dadurch gekennzeichnet, daß die Lichtleitvorrichtung (12) aus Umlenkprismen (15, 16), Lichtleitstäben (17, 18) und einem zylinderförmigen Lichtleiter (19) aufgebaut ist.

4. Detektor nach Anspruch 1, dadurch gekennzeichnet, daß die Lichtleitvorrichtung (22) an einer Hauptoberfläche (11f) des Szintillatorkristalles (11) angesetzt ist.

5. Detektor nach Anspruch 4, dadurch gekennzeichnet, daß die Lichtleitvorrichtung (22) aus einem plattenförmigen Teil (25) mit Spiegelflächen (25b, 25c), Lichtleitstäben (17, 18) und einem zylinderförmigen Lichtleiter (19) aufgebaut ist.

6. Detektor nach einem der Ansprüche 1 bis 5, dadurch gekennzeichnet, daß als Szintillatorkristall (11) YAP: Ce$^{3+}$ vorgesehen ist.

7. Detektor nach einem der Ansprüche 1 bis 6, dadurch gekennzeichnet, daß der Szintillatorkristall (11) auf der dem Präparat (42) zugewandten Oberfläche mit einer 50 nm dicken Aluminium-Schicht (44) und auf allen anderen freien Oberflächen mit einer Spiegelschicht (12a) versehen ist.

8. Detektor nach einem der Ansprüche 1 bis 7, dadurch gekennzeichnet, daß die freien Oberflächen der Lichtleitvorrichtung (12, 22) an den den Szintillatorkristall (11) umgebenden Bereichen mit einer Spiegelschicht (12a, 22a) versehen sind.

9. Detektor nach einem der Ansprüche 1 bis 8, dadurch gekennzeichnet, daß auf der dem Präparat abgewandten Seite ein Versteifungsblech (45) aufgekittet ist.

10. Detektor nach einem der Ansprüche 1 bis 9, dadurch gekennzeichnet, daß auf der dem Präparat zugewandten Seite ein Drahtnetz (46) aufgebracht ist, das bei zu geringem Abstand des Detektors vom Präparat einen Kontakt schließt, der ein Signal auslöst.

## Claims

1. Detector for back-scattered electrons having a scintillator (11), the wafer-like main-surface (11f) of which is aligned perpendicularly to the direction of the electron beam, and a light-conducting device (12, 22) consisting of solid parts, whereby the pickup of the secondary radiation from the scintillator (11) to a receiver take place in a plane which is approximately perpendicularly to the direction of the electron beam, characterized by the fact that the light-conducting device (12, 22) comprises two reflective areas (15b, 16b, 25b, 25c) placed on opposite sides of the scintillator (11) which conduct the secondary radiation by means of light-conducting rods (17, 15) to the receiver.

2. Detector according to claim 1, characterized by the fact that scintillator crystall (11) is quadratic and that the light-entering surfaces (15a, 16a) of the light-conducting device (12) are fastened to two mutually opposite side walls (11d, 11e) of the scintillator crystall (11).

3. Detector according to claim 2, characterized by the fact that the light-conducting device (12) comprises reflecting prism (15, 16), light-conducting rods (17, 18) and a cylindrically-shaped light conductor (19).

4. Detector according to claim 1, characterized by the fact that the light-conducting device is fastened to a main-surface (11f) of the scintillator crystall (11).

5. Detector according to claim 4, characterized by the fact that the light-conducting device (22) comprises a plate-chaped part (25) having reflecting surfaces (25b, 25c), light conducting rods (17, 18) and a cylindrically-schaped light conductor (19).

6. Detector according to claim 1 to 5, characterized by the fact that YAP: Ce+3 is provided as scintillator crystall (11).

7. Detector according to claim 1 to 6, characterized by the fact that the scintillator crystall (11) has on the surface facing toward the specimen (42) an aluminium layer (44) having a thickness of 50 nm and on all other exposed surfaces reflecting coatings (12a).

8. Detector according to claim 1 to 7, characterized by the fact that the exposed surfaces of the light-conducting device (12, 22) in the vicinity of the scintillator crystall (11) are provided with reflecting coatings (12a, 22a).

9. Detector according to claim 1 to 8, characterized by the fact that on the surface facing away from the specimen (42) a reinforcement piece of sheet metal is disposed.

10. Detector according to claim 1 to 9, characterized by the fact that on the surface facing toward the specimen a wire grid is mounted which closes a circuit for a signal if the distance of the detector from the specimen is too small.

## Revendications

1. Détecteur d'électrons rétrodiffusés équipé d'un scintillateur (11), dont la surface principale en forme de disque (11f) est orientée perpendiculairement à la direction du faisceau électronique, et d'un dispositif conducteur de lumière (12, 22) composé d'éléments fixes et adapté au scintillateur (11), de façon à ce que le rayonnement secondaire soit dirigé du scintillateur (11), vers un détecteur dans un plan sensiblement perpendiculaire à la direction du faisceau électronique, caractérisé en ce que le dispositif conducteur de lumière (12, 22) comprend deux faces réfléchissantes (15b, 16b, 25b, 25c) qui sont disposées sur des côtés opposés du scintillateur (11) et qui dirigent le rayonnement secondaire vers un récepteur par l'intermédiaire d'éléments conducteurs de lumière (17, 15).

2. Détecteur selon la prétention 1, caractérisé en ce que le cristal de scintillateur (11) est carré et que les faces d'entrée de la lumière (15a, 16a) du dispositif conducteur de lumière (12) sont adaptées à deux parois latérales opposées (11d, 11e) du cristal de scintillateur (11).

3. Détecteur selon la prétention 2, caractérisé en ce que le dispositif conducteur de lumière (12) est composé de prismes déviateurs (15, 16), de conducteurs de lumière (17, 18) et d'un guide de lumière cylindrique (19).

4. Détecteur selon la prétention 1, caractérisé en ce que le dispositif conducteur de lumière (22) est adapté à l'une des surfaces principales (11f) du cristal de scintillateur (11).

5. Détecteur selon la prétention 4, caractérisé en ce que le dispositif conducteur de lumière (22) est composé d'une plaque (25) avec des faces réfléchissantes (25b, 25c), d'éléments conducteurs de lumière (17, 18) et d'un guide de lumière cylindrique (19).

6. Détecteur selon l'une des prétentions 1 à 5, caractérisé en ce que le cristal de scintillateur utilisé (11) est un cristal YAP: Ce3+.

7. Détecteur selon l'une des prétentions 1 à 6, caractérisé en ce que le cristal de scintillateur (11) est recouvert d'une couche d'aluminium de 50 nm d'épaisseur (44) sur la face qui est tournée vers la préparation (42) et d'une couche réfléchissante (12a) sur toutes les autres faces dégagées.

8. Détecteur selon l'une des prétentions 1 à 7, caractérisé en ce que les faces dégagées du dispositif conducteur de lumière (12, 22) sont recouvertes d'une couche réfléchissante (12a, 22a) dans l'environnement du cristal de scintillateur (11).

9. Détecteur selon l'une des prétentions 1 à 8, caractérisé en ce qu'une tôle de stabilisation (45) est cimentée sur la face se trouvant à l'opposé de la préparation.

10. Détecteur selon l'une des prétentions 1 à 9, caractérisé en ce que la face qui est tournée vers la préparation est dotée d'un réseau de fil de fer (46) qui établit un contact déclenchant un signal d'alerte, lorsque le détecteur se trouve trop près de la préparation.

Fig.1

Fig. 2

Fig. 3a   Fig.3b   Fig.3c

Fig. 3d   Fig.3e   Fig. 3f

EP 0 191 293 B1

Fig. 4